# EUROPEAN PATENT SPECIFICATION

(11) **EP 3 470 971 B1**
(45) Date of publication and mention of the grant of the patent: **05.04.2023**
(21) Application number: 17845376.7
(22) Date of filing: 28.08.2017
(51) Int. Cl.: G06F 3/06, G11C 7/10, G06F 13/16, G06F 13/18, G06F 13/372, G06F 9/30

(54) **METHOD, APPARATUS, AND SYSTEM FOR ACCESSING MEMORY DEVICE**
VERFAHREN, VORRICHTUNG UND SYSTEM FÜR DEN ZUGRIFF AUF EINE SPEICHERVORRICHTUNG
PROCÉDÉ, APPAREIL ET SYSTÈME D'ACCÈS À UN DISPOSITIF DE MÉMOIRE

(30) Priority: 31.08.2016 CN 201610797658
(43) Date of publication of application: 17.04.2019
(73) Proprietor: Huawei Technologies Co., Ltd., Longgang District Shenzhen, Guangdong 518129 (CN)
(72) Inventor: LU, Tianyue, Beijing 100190 (CN); RUAN, Yuan, Beijing 100190 (CN); CHEN, Mingyu, Beijing 100190 (CN); CHEN, Shaojie, Shenzhen Guangdong 518129 (CN)
(74) Representative: Gill Jennings & Every LLP
(86) International application number: PCT/CN2017/099331
(87) International publication number: WO 2018/041074

(56) References cited:
- CN-A- 101 030 183
- CN-A- 102 331 977
- CN-A- 102 609 378
- CN-A- 103 136 110
- CN-A- 103 500 149
- CN-A- 104 951 412
- US-A1- 2002 039 369
- US-A1- 2008 162 790
- US-A1- 2009 089 492
- US-A1- 2012 023 286
- US-A1- 2014 204 684

## Description

### TECHNICAL FIELD

Embodiments of the present invention relate to the field of computers, and in particular, to a method, an apparatus, and a system for accessing a memory device.

### BACKGROUND

A memory system is one of most important components in a computer system. A conventional memory system uses a synchronous double data rate (Double Data Rate, DDR) protocol to exchange data. A fixed read/write latency is used in the synchronous DDR protocol, and a latency, a granularity, and an order for access are all fixed. Therefore, in the synchronous DDR protocol, only data such as data content and a requested address needs to be transmitted to complete an access action.

As different memory media emerge, the synchronous DDR protocol can no longer adapt to all memory media, especially in a hybrid memory system. Different memory media in the hybrid memory system have different access latencies. Therefore, a requirement of the system apparently cannot be met by using the DDR protocol using a fixed latency. Asynchronous access is exactly a memory protocol used to resolve such a problem. In asynchronous access, access latencies are different in different memory access. Therefore, in addition to data content and a requested address, information such as a latency identifier, an access granularity, and a request identifier further needs to be transmitted. Transmitting the information occupies a large amount of bus bandwidth, resulting in increased load on the memory system.

US 2012/0023286 discloses an apparatus and a method of page program operation for memory devices with mirror back-up of data.

US 2008/162790 discloses a NAND flash memory having c/a pin and flash memory system including the same.

US 2012/204684 discloses a Nonvolatile memory devices, memory system and related control methods

US 2009/0089492 discloses a method for accessing a memory device in a system, wherein the system comprises a memory controller and a memory device and the memory device comprises a medium controller, a memory, and a buffer, the method comprising:
- sending, by the memory controller, at least one access request to the medium controller;
- sending, by the memory controller, a query request to the medium controller based on a preset query period, wherein the query request is used to query whether data has been written into the buffer;
- adjusting the preset query period;
- reading, by the medium controller, data requested by said at least one access request and writing, by the medium controller, the data into the buffer;
- determining by the medium controller, based on the query request, whether the data has been written into the buffer;
- if data has been written into the buffer, sending by the medium controller the data to the memory controller; and
- receiving, by the memory controller, the data.

US 2002/0039369 discloses the step of dynamically adjusting a buffer polling period based on traffic in a network.

### SUMMARY

In view of this, the present invention discloses a method, and a system for accessing a memory device to implement asynchronous access to a memory device. The present invention is defined by appended claims. Additional features of the invention are presented in the dependent claims. In the following, parts of the description and drawing referring to embodiments, which are not covered by the claims, are not presented as embodiments of the invention, but as examples useful for understanding the invention.

According to a first aspect, this application provides a system comprising a memory controller for accessing a memory device, wherein the system further comprises the memory device, and the memory device comprises a medium controller, a memory and a buffer; and the memory controller comprises: a sending unit, configured to send at least one access request to the medium controller, wherein the sending unit is further configured to send a query request to the medium controller based on a preset query period, wherein the query request is used to query whether data has been written into the buffer; wherein the system is configured to dynamically adjust the preset query period based on a busy degree of an interconnection channel between the memory controller and the memory device; such that, when the interconnection channel is relatively busy, the preset query period is prolonged and, when the interconnection channel is relatively idle, the preset query period is shortened and wherein the medium controller is configured to read data requested by said at least one access request , to write the data into the buffer and to determine, based on the query request, whether the data has been written into the buffer, and if data has been written into the buffer, send the data to the memory controller, the memory controller further comprising a receiving unit, configured to receive the data.

In a scenario in which storage media of a memory device have different access latencies, the memory controller actively sends a query request to the medium controller, so as to implement an operation of accessing the memory device without adding an additional signal cable. After the medium controller receives the query request, if it is determined that data has been written into the buffer, the medium controller may consider the query request as one instruction for reading the buffer, and return the data that has been written into the buffer to the memory controller.

With reference to the first aspect, in a first possible implementation of the first aspect, after determining that data has been written into the buffer, the medium controller is further configured to send a response message to the memory controller, where the response message is used to indicate that a data write status of the buffer is "already written with data"; the memory controller is further configured to: trigger a buffer read request based on the response message, and send the buffer read request to the medium controller, where the buffer read request is used to read the data that has been written into the buffer; and the medium controller is further configured to: receive the buffer read request, read, based on the buffer read request, the data that has been written into the buffer, and trigger the operation of sending the data that has been written into the buffer to the memory controller.

The query request is used to query whether data has been written into the buffer, and the memory controller uses the buffer read request to implement an operation of reading the buffer, so as to further reduce complexity of a storage protocol. Specifically, an amount of data in the buffer may be carried in the response message, and the memory controller may trigger the buffer read request based on the amount of data in the buffer. For example, if only one fixed-size piece of data can be read from the buffer once, and if the response message indicates that there are currently M pieces of data in the buffer, the memory controller may trigger M buffer read requests. The one piece of data means data that can be requested by one access request.

The preset query period is dynamically adjusted based on a busy degree of an interconnection channel between the memory controller and the memory device such that, when the interconnection channel is relatively busy, the preset query period is prolonged and, when the interconnection channel is relatively idle, the preset query period is shortened. When a bus or the channel is relatively busy, the preset query period is prolonged, to reduce query request sending frequency, and reduce occupancy of the bus or the channel. When a bus or the channel is relatively idle, the preset query period is shortened, to increase query request sending frequency, so that the memory controller can read to-be-accessed data as soon as possible.

According to the technical solutions disclosed in the present invention, in a scenario in which storage media of a memory device have different access latencies, the memory controller actively sends a query request to the medium controller, so as to implement an operation of accessing the memory device without adding an additional signal cable. In comparison with an asynchronous protocol, in the embodiments of the present invention, less signaling is used to implement access to a hybrid memory system. Moreover, because the query request may be implemented by using a read instruction in a storage protocol, the embodiments of the present invention have higher compatibility with various storage protocols.

### BRIEF DESCRIPTION OF DRAWINGS

To describe the technical solutions in the embodiments of the present invention more clearly, the following briefly describes the accompanying drawings required for describing the embodiments.
FIG. 1 is a schematic diagram of a logical structure of a computer system;
FIG. 2 (a) and FIG. 2 (b) are schematic diagrams of a logical structure of a memory device according to an embodiment of the present invention;
FIG. 3 is a schematic diagram of a logical structure of a computer system;
FIG. 4 is a schematic flowchart of a method for accessing a memory device according to an embodiment of the present invention;
FIG. 5 is a schematic timing diagram of a method for accessing a memory device according to an embodiment of the present invention;
FIG. 6 is a schematic timing diagram of a method for accessing a memory device according to an embodiment of the present invention;
FIG. 7 is a schematic timing diagram of a method for accessing a memory device according to an embodiment of the present invention;
FIG. 8 is a schematic timing diagram of a method for accessing a memory device according to an embodiment of the present invention;
FIG. 9 is a schematic timing diagram of a method for accessing a memory device according to an embodiment of the present invention;
FIG. 10 is a schematic timing diagram of a method for accessing a memory device according to an embodiment of the present invention;
FIG. 11 is a schematic flowchart of a method for accessing a memory device according to an example not covered by the claims;
FIG. 12 is a schematic timing diagram of a method for accessing a memory device according to an example not covered by the claims;
FIG. 13 is a schematic diagram of a hardware structure of an apparatus for accessing a memory device according to an embodiment of the present invention;
FIG. 14 is a schematic diagram of a logical structure of a memory controller according to an embodiment of the present invention;
FIG. 15 is a schematic diagram of a logical structure of a memory controller according to an example not covered by the claims; and
FIG. 16 is a schematic diagram of a logical structure of a medium controller according to an embodiment of the present invention.

### DESCRIPTION OF EMBODIMENTS

The following describes the embodiments of the present invention with reference to the accompanying drawings.

During memory access, if an access latency of a memory medium is unknown, for example, because different memory media in a hybrid memory system have different access latencies, a requirement of the system apparently cannot be met by using a synchronous double data rate (Double Data Rate, DDR) protocol using a fixed latency. More specifically, because a dynamic random access memory (dynamic random access memory, DRAM) and a non-volatile memory chip are integrated in a non-volatile dual in-line memory module (non-volatile dual in-line memory module, NVDIMM), the conventional DDR protocol cannot meet the requirement of the system.

If an asynchronous access protocol is used, latencies are different in different memory access. Therefore, when a memory controller accesses a memory device, not only address information of data but also an additional latency identifier and other additional information such as length information and a request identifier of a request packet need to be transmitted. Alternatively, an additional signal cable needs to be added between the memory controller and the memory device. The memory device actively pushes a status of an access request to the memory controller by using the additional signal cable.

The present invention is to resolve some of the foregoing problems. According to the embodiments of the present invention, the memory controller sends a query instruction to the memory device to query a status of an access request, so as to implement access to memory media having different latencies without modifying a conventional storage protocol (for example, DDR).

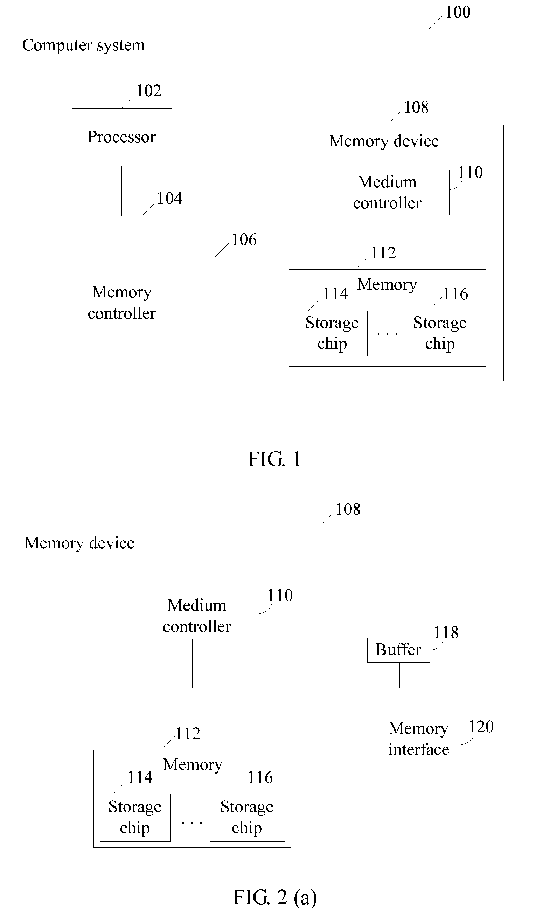

FIG. 1 is a schematic architectural diagram of a computer system 100 according to an embodiment of the present invention. The system 100 includes one or more processors 102, a memory controller 104, and a memory device 108. In a specific implementation process, the processor 102, the memory controller 104, and the memory device 108 may be located on a same mainboard, but this is not limited in the present invention. For example, the memory device 108 may be a remote memory. The memory controller 104 is interconnected to the memory device 108 by using a network protocol.

The processor 102 may be a general-purpose central processing unit (Central Processing Unit, CPU), a microprocessor, an application-specific integrated circuit (Application Specific Integrated Circuit, ASIC), a field programmable gate array (Field Programmable Gate Array, FPGA), or one or more integrated circuits. A specific implementation form of the processor 102 is not limited in this embodiment of the present invention.

The memory controller 104 is configured to: respond to an access request from the processor 102, and communicate with the memory device 108 by using an interconnection channel 106. The interconnection channel 106 may be a bus or another connection form. A connection form between the memory controller 104 and the memory device 108 is not limited in this embodiment of the present invention. For example, the memory controller 104 and the memory device 108 may be connected wirelessly. Alternatively, the memory device 108 is a remote memory. The memory controller 104 and the memory device 108 may be connected by using various network protocols.

The memory device 108 may support a plurality of storage protocols, for example, the double data rate fourth generation (Double Data Rate Fourth Generation, DDR4) protocol and an additional protocol. A storage protocol supported by the memory device 108 is not limited in this embodiment of the present invention.

The memory device 108 includes a medium controller 110 and a memory 112. The medium controller 110 is configured to: interact with the memory controller 104 and manage an access operation on the memory device 108.

The memory 112 includes a storage chip 114 and a storage chip 116, and is configured to store data required by the processor 102 of the system 100. The storage chip 114 and the storage chip 116 may be a same storage medium or different storage media. For example, in a hybrid memory system, a memory device includes different storage media. The storage chip 114 and the storage chip 116 each may be any non-volatile memory (Non-Volatile Memory, NVM), any dynamic random access memory (Dynamic Random Access Memory, DRAM), or the like. Specifically, the storage chip 114 and the storage chip 116 may be flash (Flash) memories, ferroelectric random access memories (ferroelectric random access memory, FeTRAM), nanowire-based random access memories, any DRAMs, or the like.

It should be understood that, although FIG. 1 shows that the memory 112 includes the storage chip 114 and the storage chip 116, a quantity of storage chips in the memory 112 is not limited in this embodiment of the present invention. The memory 112 may include more or fewer storage chips. The storage media used by the storage chips are not limited either in this embodiment of the present invention.

FIG. 2 (a) is a schematic architectural diagram of a memory device 108 according to an embodiment of the present invention. FIG. 2 (a) shows other details of the memory device 108.

As shown in FIG. 2 (a), the memory device 108 further includes a buffer 118 and a memory interface 120. The medium controller 110, the memory 112, the buffer 118, and the memory interface 120 may be connected by using an interconnection bus.

The buffer 118 is configured to buffer data stored in the memory 112. Specifically, after receiving an access request, the medium controller 110 first reads to-be-accessed data from the memory 112, and then writes the to-be-accessed data into the buffer 118. Subsequently, after receiving a new instruction sent by the memory controller, for example, a query request or a buffer read request described below, the medium controller 110 returns the to-be-accessed data in the buffer 118 to the memory controller 104.

More specifically, the buffer 118 may be a first in first out (First In First Out FIFO) queue. After receiving an instruction sent by the memory controller 104, the medium controller 110 returns data stored in the FIFO to the memory controller side based on an order in which data is written into the FIFO.

It should be understood that the memory device 108 may specifically include a read buffer and a write buffer. The write buffer is configured to buffer data to be written into the memory 112. The read buffer is configured to buffer data read from the memory 112. This is not limited in the present invention. For ease of description, unless otherwise indicated, the buffer 118 in this embodiment of the present invention is a read buffer.

In addition, the memory device 108 may have a plurality of buffers 118. Different buffers 118 may correspond to different access requests or correspond to access requests having different priorities. For example, access requests of a computer system may have a plurality of priorities. A priority of an access request for important data is higher than a priority of an access request for common data. Access requests having different priorities may be managed by disposing a plurality of buffers 118 in the memory device. Access requests correspond to different buffers based on different priorities. For ease of description, in this embodiment of the present invention, one of the buffers 118 is used for description. However, it should be understood that, a quantity of buffers 118 is not limited in this embodiment of the present invention.

The memory interface 120 is configured to connect to the interconnection channel 106, to implement interaction between the memory controller 104 and the medium controller 110.

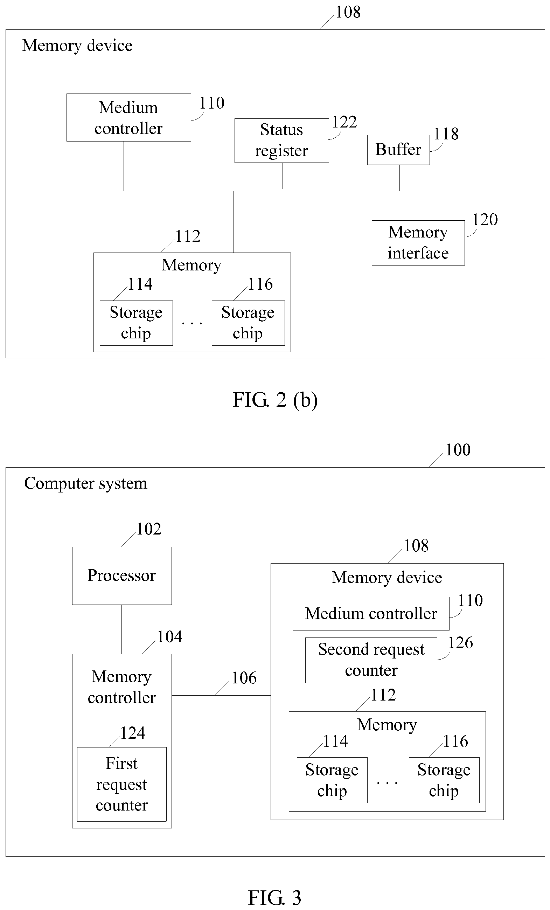

Optionally, as shown in FIG. 2 (b), the memory device 108 further includes a status register 122. The status register 122 is configured to record a data write status of the buffer 118. More specifically, if there are a plurality of buffers 118, for example, access requests having different priorities correspond to different buffers 118, for each buffer 118, one status register 122 records a data write status of the buffer 118. For ease of description, one group including one buffer 118 and one status register 122 is used for description in this embodiment of the present invention. However, it should be understood that, quantities of buffers 118 and status registers 122 are not limited in this embodiment of the present invention.

Optionally, the status register 122 may store one binary bit, and may record two states "0" and "1". For example, the state "0" may be used to indicate that no data has been written into the buffer 118, and the state "1" may be used to indicate that data has been written into the buffer 118. The medium controller 110 uses a status bit in the status register 122 to determine whether data has been written into the buffer 118.

Optionally, the status register 122 may store a plurality of binary bits, and may record a plurality of states. For example, if the status register 122 can record three binary bits, eight states can be recorded. If each access request can request one fixed-size piece of to-be-accessed data, after one piece of to-be-accessed data is written into the buffer 118 each time, the medium controller 110 updates the status register 122 by increasing a value in the status register 122 by 1. For example, if an original value in the status register 122 is "0", and the state "0" indicates that no data has been written into the buffer 118, after writing to-be-accessed data into the buffer 118, the medium controller 110 may set the value in the status register 122 to "1", to indicate that one piece of to-be-accessed data has been written into the buffer 118. If the value in the status register 122 is not "0", for example, is "2", it indicates that two pieces of to-be-accessed data have been written into the buffer 118. When the medium controller 110 increases the value in the status register 122 by 1 to obtain "3", it indicates that new to-be-accessed data has been written into the buffer 118, and there are currently three pieces of to-be-accessed data in the buffer 118.

For example, each access request can read one piece of 64-byte to-be-accessed data. After writing the 64-byte to-be-accessed data into the buffer 118 based on the access request, the medium controller 110 increases the value in the status register 122 by 1, to indicate that one piece of new data has been written into the buffer.

For ease of description, unless otherwise indicated, in this embodiment of the present invention, one piece of data or one piece of to-be-accessed data is data that one access request requests to read.

It should be understood that FIG. 2 (a) and FIG. 2 (b) are merely schematic architectural example diagrams of the memory device 108. In a specific implementation process, the memory device 108 may include more or fewer components, and this is not limited in this embodiment of the present invention.

For example, in a more specific implementation of this embodiment of the present invention, as shown in FIG. 3, the memory controller 104 further includes a first request counter 124, and the memory device includes a second request counter 126.

The first request counter 124 is configured to mark an access request sent by the memory controller 104 to the memory device 108. For example, each time the memory controller 104 sends one access request, a value of the first request counter 124 increases by 1, and the value of the first request counter 124 is used as a request ID to mark the sent access request. The second request counter 126 keeps synchronized with the first request counter 106, and is configured to mark an access request received by the memory device 108. For example, each time the memory device 108 receives one access request, a value of the second request counter 126 increases by 1, and the value of the second request counter 126 is used as a request ID to mark the received access request.

The medium controller 110 maintains a correspondence between an access request and accessed data. When accessed data is returned to the memory controller 104, a request ID of an access request corresponding to the accessed data is carried, and is used to identify a ranking of the accessed data. The memory controller 104 adjusts the ranking of the accessed data based on the request ID.

When the values of the first request counter 124 and the second request counter 126 reach maximum values that can be supported, a reset operation may be performed on the request counters, in other words, the values of the request counters are set to 0 again. Counting manners of the first request counter 124 and the second request counter 126 are not limited in this embodiment of the present invention. For example, the first request counter 124 and the second request counter 126 may alternatively be used to mark an access request in a manner of subtraction by 1.

The memory controller 104 and the medium controller 110 described in this embodiment of the present invention may be implemented by using programmable logic such as an ASIC or an FPGA.

The memory controller 104 and the medium controller 110 described in this embodiment of the present invention may alternatively be implemented by using a readable storage medium storing a computer executable instruction. The readable storage medium may be a read-only memory (Read Only Memory, ROM), a static storage device, a dynamic storage device, a random access memory (Random Access Memory, RAM), or the like, or another type of readable medium suitable for storing the computer executable instruction. For example, in this embodiment of the present invention, a downloadable computer instruction may be used, and may be transferred from a remote computer (for example, a server) to a requesting computer (for example, a client) through network transmission.

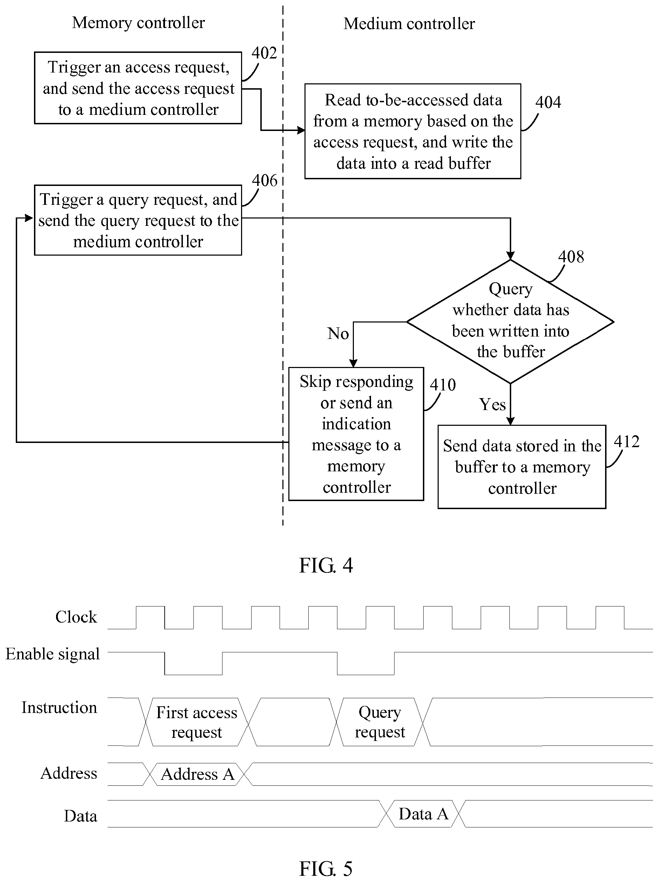

FIG. 4 is a schematic flowchart of a method for accessing a memory device according to an embodiment of the present invention. As shown in FIG. 4, the method includes the following steps.

S402: A memory controller triggers an access request, and sends the access request to a medium controller.

Specifically, the memory controller sends at least one access request to the medium controller. Each access request carries address information of requested to-be-accessed data in a memory of a memory device.

The access request may be triggered by the memory controller after the memory controller receives an access instruction sent by a processor.

More specifically, the address information of the to-be-accessed data may be physical address information of the to-be-accessed data in the memory. The access instruction sent by the processor carries virtual address information of the to-be-accessed data. The memory controller is further configured to convert the virtual address information of the to-be-accessed data into the physical address information based on a mapping relationship between a virtual address and a physical address.

During specific implementation, the medium controller may maintain the mapping relationship between a virtual address and a physical address. The address information carried in the access request may be the virtual address information of the to-be-accessed data.

In a specific implementation process, a size of to-be-accessed data that each access request can read may be a fixed value. To be specific, each access request can read one fixed-size piece of to-be-accessed data. For example, one access request can read 64-byte data. If the size of to-be-accessed data that each access request can request is a fixed value, the address information of the to-be-accessed data in the access request may be a starting address of the to-be-accessed data in the memory device.

It should be understood that forms of the access request and the address information of the to-be-accessed data are not limited in this embodiment of the present invention.

S404: The medium controller receives the access request, reads to-be-accessed data from a memory based on the access request, and writes the to-be-accessed data into a buffer.

After receiving each access request, the medium controller reads to-be-accessed data from the memory based on address information carried in the access request, and writes the data into the buffer. After the to-be-accessed data is written into the buffer, the data is in a ready state, indicating that the data can be read by the memory controller. When receiving, from the memory controller, an instruction for reading the buffer, the medium controller may return the data that has been written into the buffer to the memory controller.

Different storage media have different access latencies. Therefore, a time required for a process in which the medium controller reads to-be-accessed data from the memory and writes the data into the buffer is not transparent to the memory controller. The memory controller cannot know a time at which the medium controller completes the process. The memory controller needs to actively send a new instruction to query whether data has been written into the buffer.

S406: The memory controller sends a query request to the medium controller, where the query request is used to query whether data has been written into the buffer.

This embodiment of the present invention is applicable to a scenario in which an access latency of a memory medium is unknown during memory access. For example, different memory media in a hybrid memory system have different access latencies. Therefore, a requirement of the system apparently cannot be met by using a DDR protocol using a fixed latency. Because the memory controller does not know an access latency of the to-be-accessed data, the memory controller cannot know a time point at which the to-be-accessed data is written into the buffer. Therefore, a query request needs to be used to query whether data has been written into the buffer.

The memory controller sends the query request to the medium controller based on a preset query period.

The preset query period is dynamically adjusted based on a busy degree of an interconnection channel between the memory controller and the memory device. When a bus or the channel is relatively busy, the preset query period is prolonged, to reduce query request sending frequency, and reduce occupancy of the bus or the channel. When a bus or the channel is relatively idle, the preset query period is shortened, to increase query request sending frequency, so that the memory controller can read to-be-accessed data as soon as possible.

The preset query period may be further determined based on a priority of the access request, a plurality of access requests sent by the memory controller have at least two priorities, the memory device includes at least two buffers, and each buffer corresponds to one priority. A query period of an access request is determined based on a priority of the access request, and access requests having different priorities correspond to different query periods.

Access requests of a computer system may have a plurality of priorities. Access requests having different priorities may be managed by disposing a plurality of buffers in the memory device. Each buffer corresponds to an access request of one priority. For a buffer having a high priority, more frequent query requests may be used to ensure an operation latency for the corresponding high-priority access request.

Optionally, in an example not covered by the present claims, to ensure normal data communication, the memory controller may further send a query instruction to the medium controller after determining that an interconnection channel between the memory controller and the memory device is in an idle state.

It should be understood that some steps in this embodiment of the present invention may be performed without an order. For example, step S404 and step S406 may be performed without an order. When the memory controller sends the query request, the medium controller may have read, from the memory, the data requested by the access request and written the data into the buffer, or may have not written the data requested by the access request into the buffer.

S408: The medium controller receives the query request, determines whether data has been written into the buffer, and if it is determined that no data has been written into the buffer, performs step S410, or if it is determined that data has been written into the buffer, performs step S412.

The medium controller may record a data write status of the buffer by maintaining remaining space of the buffer. If the remaining space is the same as storage space of the buffer, it indicates that currently no data has been written into the buffer. If the remaining space is less than storage space of the buffer, it indicates that currently data has been written into the buffer, and a size of the data that has been written into the buffer is a difference between the storage space and the remaining space of the buffer. More specifically, the medium controller may maintain the remaining space of the buffer by maintaining a writable address bit of the buffer.

The medium controller may record a data write status of the buffer by using a status register. After writing the to-be-accessed data into the buffer, the medium controller updates the status register. The status register is configured to record the data write status of the buffer. After receiving the query request, the medium controller reads the data write status of the buffer that is recorded in the status register, and determines, based on the data write status of the buffer, whether data has been written into the buffer.

The query request may be a read instruction for reading the status register, and the query request carries an address of the status register, so that the query request can be implemented by using a read instruction supported by storage protocols, and the query request can be compatible with the storage protocols.

After reading data in the status register, the medium controller performs a reset operation on the status register.

The query request sent by the memory controller to the medium controller further carries buffer indication information, and the buffer indication information is used to indicate the buffer queried by the query request. When the memory controller queries a data write status of a specific buffer, the query request needs to carry indication information of the queried buffer. The indication information may be specifically address information of the buffer, address information of the status register recording the data write status of the buffer, or the like.

S410: The medium controller does not respond to the query request of the memory controller or sends an indication message to the memory controller, where the indication message is used to indicate that no data has been written into the buffer.

An access latency of a memory medium is unknown. Therefore, when the memory controller sends a query instruction, possibly no data has been written into the buffer. The medium controller may not respond to the query request, or send the indication message to the memory controller. The indication message is used to indicate that no data exists in the buffer.

If the memory controller has not received a response of the medium controller within a fixed time or receives the indication message that is sent by the medium controller and that is used to indicate that no data exists in the buffer, the memory controller may repeatedly send a query request to the medium controller by using a particular policy. For a detailed policy, refer to S406. Details are not described herein again.

S412: The medium controller sends the data that has been written into the buffer to the memory controller.

If it is determined that data has been written into the buffer, the medium controller sends the data that has been written into the buffer to the memory controller.

In this embodiment of the present invention, an access latency of a storage medium is unknown. Therefore, a requirement of the system apparently cannot be met by using a synchronous storage protocol such as a DDR protocol using a fixed latency. After the memory controller sends an access request to the medium controller, an access latency is unknown, and the medium controller cannot actively return data to the memory controller without receiving an explicit instruction. Therefore, to determine a status of the to-be-accessed data, the memory controller needs to send a query instruction to the medium controller to read data in the buffer.

In a specific implementation of this embodiment of the present invention, the query instruction has two functions. One function is querying the data write status of the buffer, and the other function is implementing an operation of reading the buffer if data has been written into the buffer. After the medium controller receives the query request, if it is determined that data has been written into the buffer, the medium controller may consider the query request as one instruction for reading the buffer, and return the data that has been written into the buffer to the memory controller.

FIG. 5 is a schematic timing diagram of a procedure of accessing a memory device according to an embodiment of the present invention. As shown in FIG. 5, an enable signal is valid at a low level. When the enable signal is at a low level, at a rising edge of a clock, a medium controller receives an access request from a memory controller. The access request carries an address A of to-be-accessed data A in a memory device. When the enable signal is at another low level, at the rising edge of the clock, the medium controller receives a query request from the memory controller. The medium controller queries a buffer based on the query request. If the data A has been written into the buffer, the medium controller returns the data A to the memory controller in response to the query request.

In another specific implementation of this embodiment of the present invention, before sending the to-be-accessed data in the buffer to the memory controller, the medium controller further sends a response message to the memory controller. The response message is used to indicate that a data write status of the buffer is "already written with data". The memory controller triggers a buffer read request based on the response message, and sends the buffer read request to the medium controller. The buffer read request is used to read the data that has been written into the buffer. The medium controller is further configured to: receive the buffer read request sent by the memory controller, read, based on the buffer read request, the data that has been written into the buffer, and trigger the operation of sending the data that has been written into the buffer to the memory controller.

The query request is used to query whether data has been written into the buffer, and the buffer read request is used to implement an operation of reading the buffer, so as to further reduce complexity of a storage protocol.

The buffer read request is specifically one instruction for reading the buffer, and carries address information of the buffer. After receiving the buffer read request, the medium controller triggers step S412.

The response message is used to indicate that data has been written into the buffer. More specifically, the response message may further indicate an amount of to-be-accessed data in the buffer. To be specific, the response message further carries the amount M of to-be-accessed data in the buffer. The buffer read request may carry amount information of data that the buffer read request requests to read in the buffer, and the amount information is generated based on the amount M.

If one buffer read request can read only one piece of to-be-accessed data in the buffer, in other words, to-be-accessed data, for example, 64-byte fixed data, of only one access request can be read, the memory controller may send M buffer read requests to the medium controller based on the response message, to read all data in the buffer. After receiving the M buffer read requests, the medium controller returns to-be-accessed data in the buffer to the memory controller. M is a positive integer greater than 0.

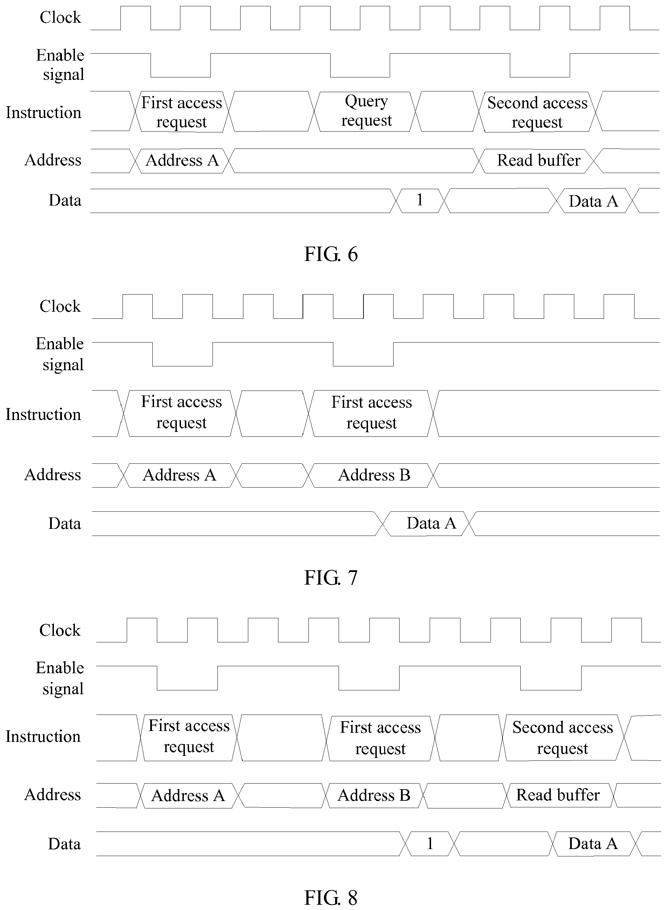

FIG. 6 is a schematic timing diagram of a procedure of accessing a memory device according to an embodiment of the present invention. As shown in FIG. 6, after receiving a query request, a medium controller queries whether data has been written into a buffer. If data has been written, the medium controller sends a response message to a memory controller. The response message carries a data write status of the buffer. As shown in FIG. 6, the medium controller sends a value "1" to the memory controller side in response to the query request. The value "1" is used to indicate that currently data has been written into the buffer. More specifically, the value "1" may be used to indicate that currently one piece of data has been written into the buffer. The memory controller sends a buffer read request to the medium controller based on the response message. The buffer read request is used to read data in the buffer. The medium controller sends data A to the memory controller based on the buffer read request.

In another specific implementation of this embodiment of the present invention, an access request cannot directly make the medium controller return to-be-accessed data requested by the access request. Due to such a characteristic of the access request, to reduce a quantity of times of interaction between the memory controller and the medium controller, the query request may be implemented by using a new access request.

For example, after the memory controller sends an access request for reading an address A, the medium controller fetches the data A indicated by the address A from a memory, and writes the data A into the buffer. Subsequently, the memory controller further sends an access request for reading an address B, and the access request for reading the address B can also implement a query instruction function. After receiving the access request for reading the address B, the medium controller reads data B indicated by the address B from the memory based on the access request for reading the address B, writes the data B into the buffer, queries the data write status of the buffer based on the access request for reading the address B, and directly returns the data A to the memory controller or sends a response message to the memory controller.

In this implementation, an amount of signaling exchanged between the memory controller and the medium controller is reduced, and load on a communications bus or a channel is lightened.

FIG. 7 and FIG. 8 are schematic timing diagrams. In FIG. 7, after a medium controller receives an access request for reading an address B, if data A has been written into a buffer, the medium controller directly returns the data A in the buffer to a memory controller. In FIG. 8, after a medium controller receives an access request for reading an address B, if data A has been written into a buffer, the medium controller sends a response message to a memory controller, the memory controller sends a buffer read request to the medium controller based on the response message, and the medium controller returns the data A to the memory controller based on the buffer read request. For specific implementation of FIG. 7 and FIG. 8, refer to FIG. 5 and FIG. 6. Details are not described herein again.

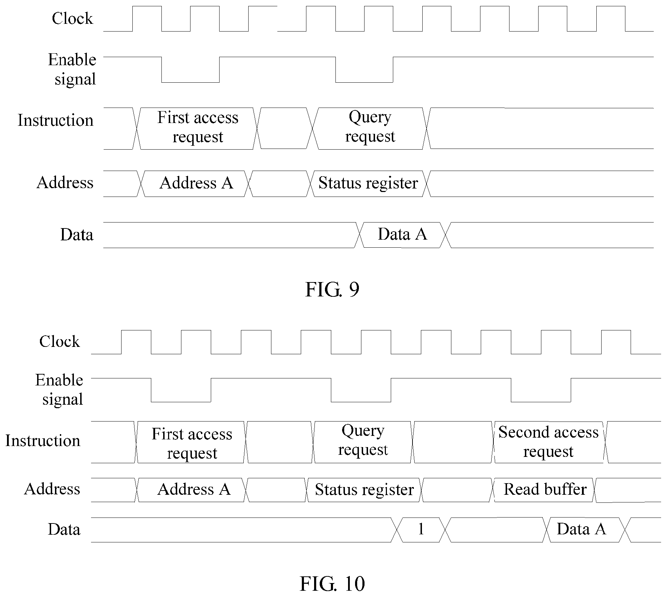

In another specific implementation of this embodiment of the present invention, the medium controller records a data write status of the buffer by using a status register. FIG. 9 and FIG. 10 are schematic timing diagrams. As shown in FIG. 9 and FIG. 10, a query request further carries address information of a status register, and the query request carries an address of the status register. After receiving the query request, a medium controller reads a value in the status register based on the address information of the status register. If the value is "0", it indicates that currently no data has been written into a buffer. If the value is not "0", it indicates that currently data has been written into a buffer. The medium controller may further determine, based on a specific value in the status register, an amount of data that has been written into the buffer.

In FIG. 9, if the value in the status register is not "0", the medium controller directly returns data in the status register to a memory controller. In FIG. 10, if the value in the status register is not "0", the medium controller returns data in the status register to a memory controller. For specific implementation of FIG. 9 and FIG. 10, refer to FIG. 5 and FIG. 6. Details are not described herein again.

In another implementation of this embodiment of the present invention, the memory controller can read only one piece of to-be-accessed data in the buffer by using one read instruction for the buffer, and the memory system considers the query request as one instruction for reading the buffer, so that a quantity of times of interaction between the memory controller and the medium controller is reduced.

Specifically, if only one piece of to-be-accessed data exists in the buffer, the medium controller may directly send the to-be-accessed data to the memory controller. If M is a positive integer greater than 1, the medium controller may send one piece of to-be-accessed data that has been first written into the buffer to the memory controller side based on a query instruction. For example, the buffer is a FIFO. The medium controller sends one piece of to-be-accessed data at the head of the queue to the memory controller, and sends a response message to the memory controller. The response message indicates an amount of remaining to-be-accessed data in the buffer. After receiving the response message, the memory controller needs to send only M-1 buffer read requests to the medium controller. After receiving the M-1 buffer read requests, the medium controller returns remaining M-1 pieces of to-be-accessed data in the buffer to the memory controller.

In this embodiment of the present invention, in an asynchronous access manner, the to-be-accessed data may be returned out of order. Therefore, when sending the data that has been written into the buffer to the memory controller, the medium controller further sends identification information to the memory controller. The identification information is used to indicate an access request corresponding to the data sent by the medium controller. To be specific, the identification information is used to indicate a correspondence between the to-be-accessed data and an access request.

Specifically, the identification information may be carried in data sent by the medium controller and is sent to the memory controller together with the data. Alternatively, data and identification information of the data may be sent alternately. It should be understood that a manner of sending data and identification information of the data is not limited in this embodiment of the present invention.

Specifically, in this embodiment of the present invention, a request ID is used to identify to-be-accessed data returned each time. When sending the to-be-accessed data to the memory controller, the medium controller further returns a request ID of an access request corresponding to the to-be-accessed data to the memory controller, to implement out-of-order return of data.

In a specific implementation process, when sending an access request, the memory controller may also send a request ID corresponding to the access request to the medium controller.

In this embodiment of the present invention, the request ID may alternatively be recorded through synchronization between the memory controller and the medium controller. To be specific, the memory controller and the medium controller each have a request counter. A value of the request counter is used to record a request ID of an access request. Each time the memory controller sends one access request, a value of a first request counter on the memory controller side automatically increases by 1. Each time the medium controller receives one request, a value of a second request counter on the medium controller side automatically increases by 1. During returning of to-be-accessed data, a request ID is transferred to the memory controller together with the to-be-accessed data. An order in which access requests are sent is definitely consistent with an order in which the access requests are received. Therefore, request IDs are synchronized between the memory controller and the medium controller, so that out-of-order return for access requests is implemented. Detailed descriptions of the request counters are already provided above. Details are not described herein again.

According to the technical solution disclosed in this embodiment of the present invention, in a scenario in which storage media of a memory device have different access latencies, the memory controller actively sends a query request to the medium controller, so as to implement an operation of accessing the memory device without adding an additional signal cable. In comparison with an asynchronous protocol, in this embodiment of the present invention, less signaling is used to implement access to the hybrid memory system. Moreover, because the query request may be implemented by using a read instruction in a storage protocol, this embodiment of the present invention has higher compatibility with various storage protocols.

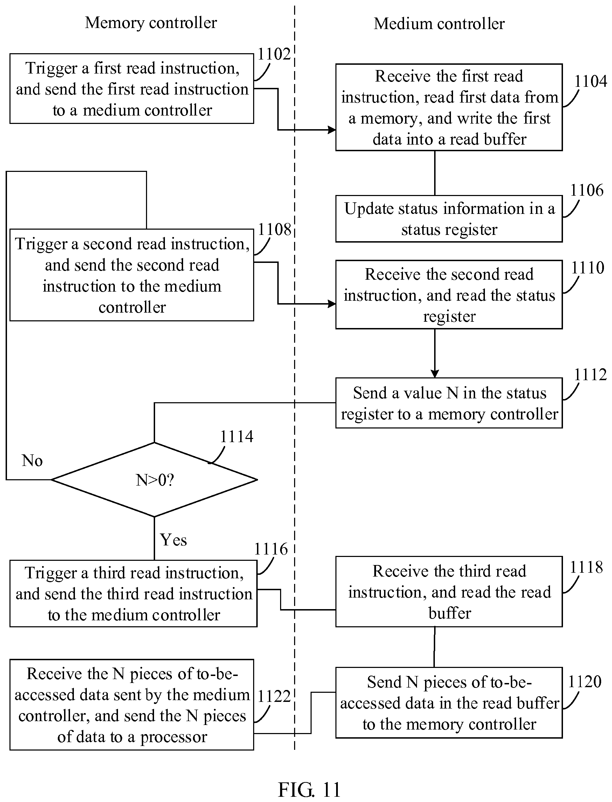

In the embodiments of the present invention, for compatibility with a storage protocol, an access request, a query request, and a buffer read request may all be implemented by using read instructions in the storage protocol. FIG. 11 is a schematic flowchart of a specific method for accessing a memory device according to an example not covered by the claims. As shown in FIG. 11, the method includes the following steps.

S1102: A memory controller triggers a first read instruction, and sends the first read instruction to a medium controller.

The first read instruction carries address information of to-be-accessed data in a memory device. One piece of to-be-accessed data that can be read by the first read instruction has a fixed size, for example, 64 bytes. For ease of description, in the following description, a size of one piece of to-be-accessed data is 64 bytes. However, it should be understood that, the size of one piece of to-be-accessed data is not limited in this example.

After sending the first read instruction, the memory controller increases a value of a first request counter on the memory controller side by 1, and uses a value of the first request counter obtained after the increase of 1 as a request ID of the access request. The request ID is used to identify the first read instruction.

S 1104: The medium controller receives the first read instruction, reads, based on address information carried in the first read instruction, 64-byte to-be-accessed data from a memory of a memory device, and writes the to-be-accessed data into a buffer.

After receiving the first read instruction, the medium controller increases a value of a second request counter on the medium controller side by 1 to keep synchronized with the first request counter on the memory controller side, and uses a value of the request counter obtained after the increase of 1 as the request ID of the access request. The request ID is used to identify the first read instruction. More specifically, the medium controller maintains a correspondence between the to-be-accessed data and the first read instruction, to be specific, records a request ID corresponding to each piece of to-be-accessed data, to implement out-of-order return of data.

S1106: After writing the to-be-accessed data into the buffer, the medium controller updates a data write status of the buffer that is recorded in a status register.

The data write status may be a specific value, and is used to indicate a current amount of to-be-accessed data in the buffer. After writing the to-be-accessed data into the buffer, the medium controller increases a value in the status register by 1.

S1108: The memory controller triggers a second read instruction, and sends the second read instruction to the medium controller.

Specifically, the second read instruction carries an address of the status register, and is used to read the data write status of the buffer that is recorded in the status register.

S1110: The medium controller receives the second read instruction, and reads the status register based on an address of the status register that is carried in the second read instruction.

After reading a value N in the status register, the medium controller resets the status register.

S1112: The medium controller sends a value N in the status register to the memory controller, where the value N in the status register is used to indicate a current amount N of to-be-accessed data in the buffer.

S1114: After receiving the value N in the status register that is sent by the medium controller, the memory controller determines whether N is greater than 0; and if N is 0, it indicates that currently no to-be-accessed data has been written into the buffer, and the memory controller performs step S1108 again to send the second read instruction to the medium controller again based on a particular policy; or if N is greater than 0, the memory controller performs step S1116.

S1116: The memory controller triggers a third read instruction, and sends the third read instruction to the medium controller.

The third read instruction carries address information of the buffer, and is used to read the to-be-accessed data in the buffer.

Specifically, if one third read instruction can read a plurality of pieces of to-be-accessed data, the third read instruction further carries amount indication information of to-be-read data. The amount indication information is generated based on the value N. If each third read instruction can read only one piece of to-be-accessed data, the memory controller sends N third read instructions to the medium controller. Each third read instruction is used to read one piece of 64-byte to-be-accessed data.

S1118: The medium controller receives the third read instruction, and reads the to-be-accessed data in the buffer based on address information of the buffer that is carried in the third read instruction.

Specifically, the buffer may be a FIFO. If each third read instruction can read only one piece of to-be-accessed data, each third read instruction reads one piece of to-be-accessed data at the head of the FIFO queue. N third read instructions can read the first N pieces of to-be-accessed data from the buffer.

S1120: The medium controller sends, to the memory controller, N pieces of to-be-accessed data read from the buffer.

Specifically, each piece of to-be-accessed data carries a request ID corresponding to the piece of data, to indicate a request ranking of the to-be-accessed data.

S1122: The memory controller receives the N pieces of to-be-accessed data sent by the medium controller, and sends the N pieces of to-be-accessed data to a processor.

Specifically, each piece of to-be-accessed data carries a request ID of a first read instruction corresponding to the piece of data. Therefore, before sending the to-be-accessed data to the processor, the memory controller may further resort, based on the request ID in the to-be-accessed data, the to-be-accessed data that is returned out of order, so as to ensure data correctness and integrity.

The embodiment of FIG. 11 is a specific implementation of the embodiment of FIG. 3. Specific descriptions of the embodiment of FIG. 3 are applicable to this example Details are not described herein again.

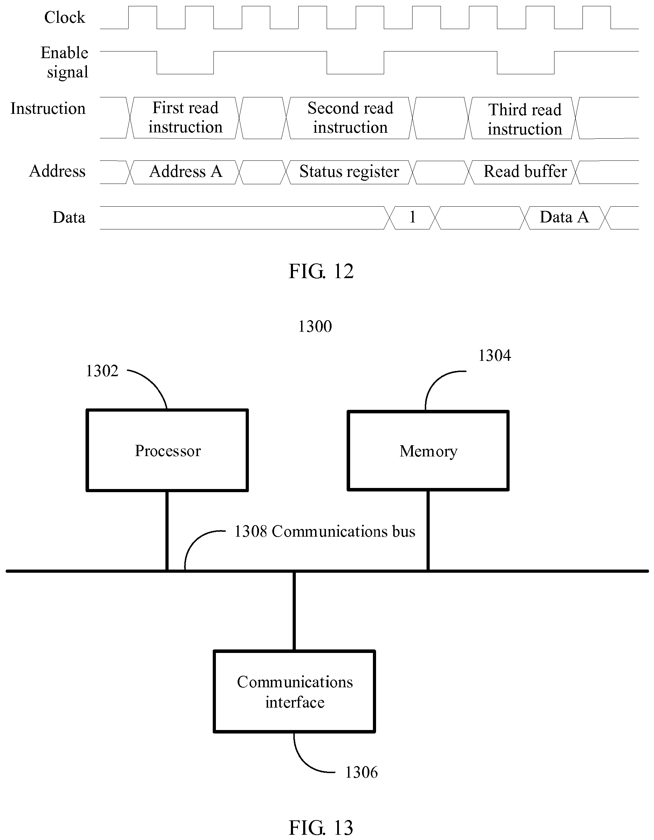

FIG. 12 is a schematic timing diagram of the method for accessing a memory device in the example of FIG. 11. As shown in FIG. 12, when an enable signal is at a low level, a medium controller receives a first read instruction at a rising edge of a clock. The first read instruction carries an address A of to-be-accessed data A. When the enable signal is at another low level, at the rising edge of the clock, the medium controller receives a second read instruction sent by a memory controller. The second read instruction carries address information of a status register. The medium controller reads a value in the status register, and returns the value "1" to the memory controller. The value "1" is used to indicate that currently one piece of to-be-accessed data exists in a buffer. When the enable signal is at still another low level, at the rising edge of the clock, the medium controller receives a third read instruction from the memory controller. The third read instruction carries address information of the buffer. The medium controller reads the buffer, and returns the data A in the buffer to the memory controller.

A hardware structure of the memory controller or the medium controller described in the embodiments of the present invention may be implemented by using an apparatus 1300 shown in FIG. 13. As shown in FIG. 13, the apparatus 1300 includes a processor 1302, a memory 1304, a communications interface 1306, and a bus 1308. The processor 1302, the memory 1304, and the communications interface 1306 are communicatively connected to each other by using the bus 1308.

The processor 1302 is a control center of the apparatus 1300, and is configured to execute related programs, to implement the technical solutions provided in the embodiments of the present invention. The processor 1302 may be a general-purpose central processing unit, a microprocessor, an application-specific integrated circuit, or one or more integrated circuits, and is configured to execute related programs, to implement the technical solutions provided in the embodiments of the present invention.

The memory 1304 may be a read-only memory, a static storage device, a dynamic storage device, or a random access memory. When software or firmware is used to implement the technical solutions provided in the embodiments of the present invention, program code for implementing the technical solutions provided in the embodiments of the present invention is stored in the memory 1304 and is executed by the processor 1302. The memory 1304 and the processor 1302 may be integrated together, or the memory 1304 may be integrated into the processor 1302, or may be one or more storage units independent of the processor 1302.

The communications interface 1306 is but is not limited to a transceiver apparatus such as a transceiver, to implement communication between the apparatus 1300 and another device or a communications network.

The bus 1308 may include a channel for transferring information between components (for example, the processor 1302, the memory 1304, and the communications interface 1306) of the apparatus 1300.

It should be noted that although the apparatus 1300 shown in FIG. 13 shows only the processor 1302, the memory 1304, the communications interface 1306, and the bus 1308, in a specific implementation process, persons skilled in the art should understand that the apparatus 1300 further includes other devices required for implementing normal operating. In addition, based on specific requirements, persons skilled in the art should understand that the apparatus 1300 may further include hardware devices for implementing other additional functions. Moreover, persons skilled in the art should understand that the apparatus 1300 may alternatively include only devices required for implementing the embodiments of the present invention but does not necessarily include all the devices shown in FIG. 13.

The hardware structure shown in FIG. 13 and the foregoing description are applicable to various memory controllers or medium controllers provided in the embodiments of the present invention, and are applicable to execution of various methods for accessing a memory device provided in the embodiments of the present invention.

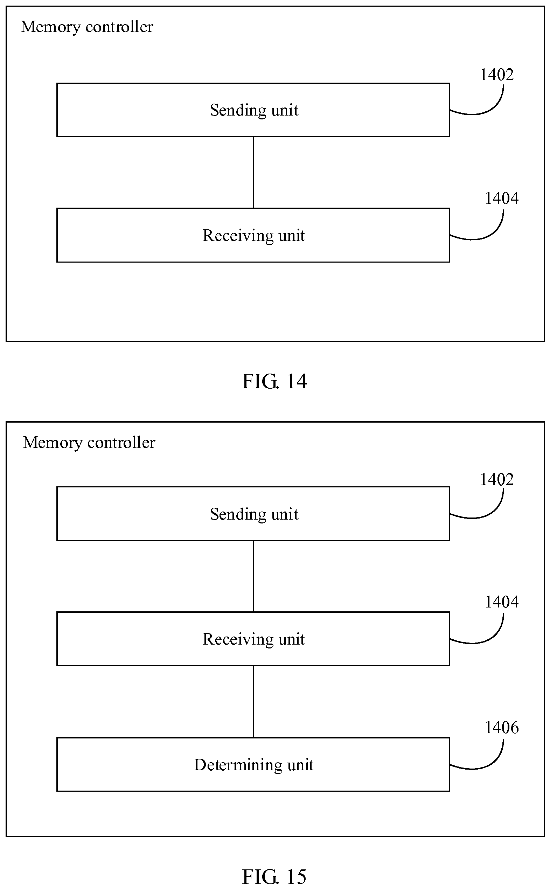

FIG. 14 is a schematic diagram of a logical structure of a memory controller according to an embodiment of the present invention. The memory controller is configured to implement access to a memory device. The memory device includes a medium controller, a memory, and a buffer. As shown in FIG. 14, the memory controller includes a sending unit 1402 and a receiving unit 1404.

The sending unit 1402 is configured to send at least one access request to the medium controller.

The sending unit 1402 is further configured to send a query request to the medium controller, where the query request is used to query whether data has been written into the buffer.

In a specific implementation process, the sending unit 1402 may be implemented by using the processor 1302, the memory 1304, and the communications interface 1306 shown in FIG. 13. More specifically, the processor 1302 may execute an executable instruction in the memory 1304, so that the communications interface performs a function of the sending unit 1402.

The sending unit 1402 sends the query request to the medium controller based on a preset query period. The preset query period may be determined based on a priority of the access request. Access requests of the memory controller may have at least two priorities, the memory device includes at least two buffers, and each buffer corresponds to one priority. A query period of an access request is determined based on a priority of the access request, and access requests having different priorities correspond to different query periods.

The query request sent by the sending unit to the medium controller further carries buffer indication information, and the buffer indication information is used to indicate the buffer queried by the query request.

As shown in FIG. 15, in an example not covered by the claims, the memory controller further includes a determining unit 1406. Before the sending unit 1402 sends the query request to the medium controller, the determining unit 1406 is configured to determine that an interconnection channel between the memory controller and the medium controller is in an idle state.

In a specific implementation process, the determining unit may be implemented by using the processor 1302 and the memory 1304 shown in FIG. 13. More specifically, in an example not covered by the claims, the processor 1302 may execute an executable instruction in the memory 1304, to determine that the interconnection channel between the memory controller and the medium controller is in an idle state.

The receiving unit 1404 is configured to receive the data that has been written into the buffer and that is sent by the medium controller.

In a specific implementation process, the receiving unit 1404 may be implemented by using the processor 1302, the memory 1304, and the communications interface 1306 shown in FIG. 13. More specifically, the processor 1302 may execute an executable instruction in the memory 1304, so that the communications interface performs a function of the receiving unit 1404.

Optionally, after the sending unit 1402 sends the query request to the medium controller, the receiving unit 1404 is further configured to receive a response message from the medium controller, where the response message is used to indicate that a data write status of the buffer is "already written with data". The sending unit 1402 is further configured to send a buffer read request to the medium controller based on the response message, where the buffer read request is used to read the data that has been written into the buffer.

The receiving unit 1404 is further configured to receive identification information sent by the medium controller, where the identification information is used to indicate an access request corresponding to the data received by the receiving unit 1404.

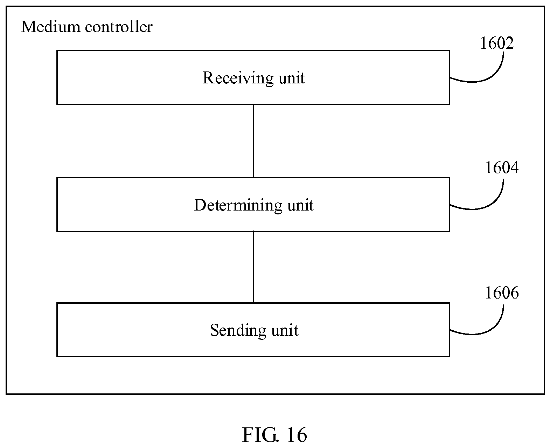

FIG. 16 is a schematic diagram of a logical structure of a medium controller according to an embodiment of the present invention. The medium controller is configured to implement access to a memory device. The memory device includes the medium controller, a memory, and a buffer. The medium controller is configured to write, into the buffer based on each received access request of a memory controller, data that is requested by each access request and that is stored in the memory. As shown in FIG. 16, the medium controller includes a receiving unit 1602, a determining unit 1604, and a sending unit 1606.

The receiving unit 1602 is configured to receive at least one access request from the memory controller.

In a specific implementation process, the receiving unit 1602 may be implemented by using the processor 1302, the memory 1304, and the communications interface 1306 shown in FIG. 13. More specifically, the processor 1302 may execute an executable instruction in the memory 1304, so that the communications interface performs a function of the receiving unit 1602.

The receiving unit 1602 is further configured to receive a query request from the memory controller, where the query request is used to query whether data has been written into the buffer.

The determining unit 1604 is configured to determine, based on the query request, whether data has been written into the buffer.

In a specific implementation process, the determining unit may be implemented by using the processor 1302 and the memory 1304 shown in FIG. 13. More specifically, the processor 1302 may execute an executable instruction in the memory 1304, to determine, based on the query request, whether data has been written into the buffer.

The sending unit 1606 is configured to: if the determining unit 1604 determines that data has been written into the buffer, send the data that has been written into the buffer to the memory controller.

In a specific implementation process, the sending unit 1606 may be implemented by using the processor 1302, the memory 1304, and the communications interface 1306 shown in FIG. 13. More specifically, the processor 1302 may execute an executable instruction in the memory 1304, so that the communications interface performs a function of the sending unit 1606.

Optionally, after the determining unit 1604 determines that data has been written into the buffer, the sending unit 1606 is further configured to send a response message to the memory controller, where the response message is used to indicate that a data write status of the buffer is "already written with data". The receiving unit 1602 is further configured to receive a buffer read request from the memory controller, where the buffer read request is used to read the data that has been written into the buffer.

Optionally, the memory device further includes a status register, and the status register is configured to record the data write status of the buffer; and the determining unit 1604 is specifically configured to: read the data write status of the buffer that is recorded in the status register, and determine, based on the data write status of the buffer, whether data has been written into the buffer.

The sending unit 1606 is further configured to send identification information to the memory controller, where the identification information is used to indicate an access request corresponding to the data sent by the sending unit 1606.

The modules described as separate parts may or may not be physically separate, and parts displayed as modules may or may not be physical modules, that is, may be located in one position, or may be distributed on a plurality of network modules. Some or all of the modules may be selected based on actual needs to achieve the objectives of the solutions of the embodiments.

In addition, function modules in the embodiments of the present invention may be integrated into one processing module, or each of the modules may exist alone physically, or two or more modules may be integrated into one module. The integrated module may be implemented in a form of hardware, or may be implemented in a form of hardware in addition to a software function module.

When the foregoing integrated module is implemented in a form of a software function module, the integrated unit may be stored in a computer-readable storage medium. The software function module is stored in a storage medium and includes instructions for instructing a computer device (which may be a personal computer, a server, or a network device) to perform some of the steps of the methods described in the embodiments of the present invention. The storage medium includes any medium that can store program code, such as a removable hard disk, a read-only memory, a random access memory, a magnetic disk, or an optical disc.

## Claims

1. A method for accessing a memory device (108) in a system, wherein the system (100) comprises a memory controller (104) and a memory device (108) and the memory device (108) comprises a medium controller (110), a memory (112), and a buffer (118), the method comprises:
sending, by the memory controller (104), at least one access request to the medium controller (110);
sending, by the memory controller (104), a query request to the medium controller (110) based on a preset query period, wherein the query request is used to query whether data has been written into the buffer (118);
dynamically adjusting the preset query period based on a busy degree of an interconnection channel between the memory controller (104) and the memory device (108) such that, when the interconnection channel is relatively busy, the preset query period is prolonged and, when the interconnection channel is relatively idle, the preset query period is shortened;
reading, by the medium controller, data requested by said at least one access request and writing, by the medium controller, the data into the buffer;
determining by the medium controller, based on the query request, whether the data has been written into the buffer;
if data has been written into the buffer, sending by the medium controller the data to the memory controller; and
receiving, by the memory controller (104), the data.

2. The method according to claim 1, wherein after the sending, by the memory controller, a query request to the medium controller, the method further comprises:
receiving, by the memory controller, a response message from the medium controller, wherein the response message is used to indicate the data has been written into the buffer; and
sending, by the memory controller, a buffer read request to the medium controller based on the response message, wherein the buffer read request is used to read the data that has been written into the buffer.

3. The method according to any one of claims 1 to 2 , wherein the memory device further comprises a status register, and the status register is configured to record the data write status of the buffer; and
read, by the medium controller, the data write status of the buffer that is recorded in the status register; and
determine, by the medium controller based on the data write status of the buffer, whether data has been written into the buffer.

4. A system comprising a memory controller for accessing a memory device, wherein the system further comprises the memory device, and the memory device comprises a medium controller, a memory and a buffer; and the memory controller comprises:
a sending unit (1402), configured to send at least one access request to the medium controller, wherein
the sending unit (1402) is further configured to send a query request to the medium controller based on a preset query period, wherein the query request is used to query whether data has been written into the buffer;
wherein the system is configured to dynamically adjust the preset query period based on a busy degree of an interconnection channel between the memory controller and the memory device such that, when the interconnection channel is relatively busy, the preset query period is prolonged and, when the interconnection channel is relatively idle, the preset query period is shortened; and
wherein the medium controller is configured to read data requested by said at least one access request, to write the data into the buffer and to determine, based on the query request, whether the data has been written into the buffer, and if data has been written into the buffer, send the data to the memory controller, the memory controller further comprising a receiving unit (1404), configured to receive the data.

5. The system according to claim 4, wherein
the receiving unit is further configured to receive a response message from the medium controller, wherein the response message is used to indicate the data has been written into the buffer; and
the sending unit is further configured to send a buffer read request to the medium controller based on the response message, wherein the buffer read request is used to read the data that has been written into the buffer.

## Patentansprüche

1. Verfahren zum Zugreifen auf eine Speichervorrichtung (108) in einem System, wobei das System (100) einen Speichercontroller (104) und eine Speichervorrichtung (108) umfasst und die Speichervorrichtung (108) einen Mediumcontroller (110), einen Speicher (112) und einen Puffer (118) umfasst, wobei das Verfahren Folgendes umfasst:
Senden mindestens einer Zugriffsanforderung zu dem Mediumcontroller (110) durch den Speichercontroller (104);
Senden einer Abfrageanforderung zu dem Mediumcontroller (110) durch den Speichercontroller (104) auf der Basis eines voreingestellten Abfragezeitraums, wobei die Abfrageanforderung verwendet wird, um abzufragen, ob Daten in den Puffer (118) geschrieben wurden;
dynamisches Justieren des voreingestellten Abfragezeitraums auf der Basis eines Belegtheitsgrads eines Verbindungskanals zwischen dem Speichercontroller (104) und der Speichervorrichtung (108) dergestalt, dass, wenn der Verbindungskanal relativ stark belegt ist, der voreingestellte Abfragezeitraum verlängert wird und wenn der Verbindungskanal relativ wenig zu tun hat, der voreingestellte Abfragezeitraum verkürzt wird;
Lesen von durch die mindestens eine Zugriffsanforderung angeforderten Daten durch den Mediumcontroller und Schreiben der Daten in den Puffer durch den Mediumcontroller;
Bestimmen durch den Mediumcontroller auf der Basis der Abfrageanforderung, ob die Daten in den Puffer geschrieben wurden;
wenn Daten in den Puffer geschrieben wurden, Senden der Daten zu dem Speichercontroller durch den Mediumcontroller; und
Empfangen der Daten durch den Speichercontroller (104).

2. Verfahren nach Anspruch 1, wobei das Verfahren nach dem Senden einer Abfrageanforderung zu dem Mediumcontroller durch den Speichercontroller ferner Folgendes umfasst:
Empfangen einer Antwortnachricht von dem Mediumcontroller durch den Speichercontroller, wobei die Antwortnachricht verwendet wird, um anzugeben, dass die Daten in den Puffer geschrieben wurden; und
Senden einer Pufferleseanforderung zu dem Mediumcontroller durch den Speichercontroller auf der Basis der Antwortnachricht, wobei die Pufferleseanforderung verwendet wird, um die Daten, die in den Puffer geschrieben wurden, zu lesen.

3. Verfahren nach einem der Ansprüche 1 bis 2, wobei die Speichervorrichtung ferner ein Statusregister umfasst und das Statusregister dafür ausgelegt ist, den Datenschreibstatus des Puffers aufzuzeichnen; und
Lesen des Datenschreibstatus des Puffers, der in dem Statusregister aufgezeichnet ist, durch den Mediumcontroller; und
Bestimmen durch den Mediumcontroller auf der Basis des Datenschreibstatus des Puffers, ob die Daten in den Puffer geschrieben wurden.

4. System, das einen Speichercontroller zum Zugreifen auf eine Speichervorrichtung umfasst, wobei das System ferner die Speichervorrichtung umfasst und die Speichervorrichtung einen Mediumcontroller, einen Speicher und einen Puffer umfasst; und der Speichercontroller Folgendes umfasst:
eine Sendeeinheit (1402), ausgelegt zum Senden mindestens einer Zugriffsanforderung zu dem Mediumcontroller, wobei
die Sendeeinheit (1402) ferner ausgelegt ist zum Senden einer Abfrageanforderung zu dem Mediumcontroller auf der Basis eines voreingestellten Abfragezeitraums, wobei die Abfrageanforderung verwendet wird, um abzufragen, ob Daten in den Puffer geschrieben wurden;
wobei das System ausgelegt ist zum dynamischen Justieren des voreingestellten Abfragezeitraums auf der Basis eines Belegtheitsgrads eines Verbindungskanals zwischen dem Speichercontroller und der Speichervorrichtung dergestalt, dass, wenn der Verbindungskanal relativ stark belegt ist, der voreingestellte Abfragezeitraum verlängert wird und wenn der Verbindungskanal relativ wenig zu tun hat, der voreingestellte Abfragezeitraum verkürzt wird; und
wobei der Mediumcontroller ausgelegt ist zum Lesen von durch die mindestens eine Zugriffsanforderung angeforderten Daten, Schreiben der Daten in den Puffer und
Bestimmen auf der Basis der Abfrageanforderung, ob die Daten in den Puffer geschrieben wurden, und wenn Daten in den Puffer geschrieben wurden, Senden der Daten zu dem Speichercontroller, wobei der Speichercontroller ferner eine zum Empfangen der Daten ausgelegte Empfangseinheit (1404) umfasst.

5. System nach Anspruch 4, wobei
die Empfangseinheit ferner ausgelegt ist zum Empfangen einer Antwortnachricht von dem Mediumcontroller, wobei die Antwortnachricht verwendet wird, um anzugeben, dass die Daten in den Puffer geschrieben wurden; und
die Sendeeinheit ferner ausgelegt ist zum Senden einer Pufferleseanforderung zu dem Mediumcontroller auf der Basis der Antwortnachricht, wobei die Pufferleseanforderung verwendet wird, um die Daten, die in den Puffer geschrieben wurden, zu lesen.

## Revendications

1. Procédé d'accès à un dispositif (108) de mémoire dans un système, le système (100) comportant un contrôleur (104) de mémoire et un dispositif (108) de mémoire et le dispositif (108) de mémoire comportant un contrôleur (110) de support, une mémoire (112), et un tampon (118), le procédé comportant :
l'envoi, par le contrôleur (104) de mémoire, d'au moins une demande d'accès au contrôleur (110) de support ;
l'envoi, par le contrôleur (104) de mémoire, d'une demande d'interrogation au contrôleur (110) de support sur la base d'une période d'interrogation préétablie, la demande d'interrogation étant utilisée pour demander si des données ont été écrites dans le tampon (118) ;
le réglage de manière dynamique de la période d'interrogation préétablie d'après un degré d'occupation d'un canal d'interconnexion entre le contrôleur (104) de mémoire et le dispositif (108) de mémoire de telle façon que, lorsque le canal d'interconnexion est relativement occupé, la période d'interrogation préétablie soit prolongée et que.
lorsque le canal d'interconnexion est relativement inactif, la période d'interrogation préétablie soit raccourcie ;
la lecture, par le contrôleur de support, de données demandées par ladite ou lesdites demandes d'accès et l'écriture, par le contrôleur de support, des données dans le tampon ;
la détermination par le contrôleur de support, d'après la demande d'interrogation, du fait que les données ont été écrites ou non dans le tampon :
si des données ont été écrites dans le tampon, l'envoi, par le contrôleur de support, des données au contrôleur de mémoire ; et
la réception des données par le contrôleur (104) de mémoire.

2. Procédé selon la revendication 1, le procédé comportant en outre, après l'envoi, par le contrôleur de mémoire, d'une demande d'interrogation au contrôleur de support :
la réception, par le contrôleur de mémoire, d'un message de réponse en provenance du contrôleur de support, le message de réponse étant utilisé pour indiquer que les données ont été écrites dans le tampon ; et
l'envoi, par le contrôleur de mémoire, d'une demande de lecture de tampon au contrôleur de support d'après le message de réponse, la demande de lecture de tampon étant utilisée pour lire les données qui ont été écrites dans le tampon.

3. Procédé selon l'une quelconque des revendications 1 à 2, le dispositif de mémoire comportant en outre un registre d'état, et le registre d'état étant configuré pour enregistrer l'état d'écriture de données du tampon ; et
la lecture, par le contrôleur de support, de l'état d'écriture de données du tampon qui est enregistré dans le registre d'état ; et
la détermination par le contrôleur de support, d'après l'état d'écriture de données du tampon, du fait que des données aient été écrites ou non dans le tampon.

4. Système comportant un contrôleur de mémoire servant à accéder à un dispositif de mémoire, le système comportant en outre un dispositif de mémoire, et le dispositif de mémoire comportant un contrôleur de support, une mémoire et un tampon ; et
le contrôleur de mémoire comportant :
une unité (1402) d'envoi, configurée pour envoyer au moins une demande d'accès au contrôleur de support, l'unité (1402) d'envoi étant en outre configurée pour envoyer une demande d'interrogation au contrôleur de support sur la base d'une période d'interrogation préétablie, la demande d'interrogation étant utilisée pour demander si des données ont été écrites dans le tampon ;
le système étant configuré pour régler dynamiquement la période d'interrogation préétablie d'après un degré d'occupation d'un canal d'interconnexion entre le contrôleur de mémoire et le dispositif de mémoire de telle façon que, lorsque le canal d'interconnexion est relativement occupé, la période d'interrogation préétablie soit prolongée et que, lorsque le canal d'interconnexion est relativement inactif, la période d'interrogation préétablie soit raccourcie ; et
le contrôleur de support étant configuré pour lire des données demandées par ladite ou lesdites demandes d'accès, pour écrire les données dans le tampon et pour déterminer, d'après la demande d'interrogation, si les données ont été écrites ou non dans le tampon, et si des données ont été écrites dans le tampon, envoyer les données au contrôleur de mémoire, le contrôleur de mémoire comportant en outre une unité (1404) de réception, configurée pour recevoir les données.

5. Système selon la revendication 4, l'unité de réception étant en outre configurée pour recevoir un message de réponse en provenance du contrôleur de support, le message de réponse étant utilisé pour indiquer que les données ont été écrites dans le tampon ;
et
l'unité d'envoi étant en outre configurée pour envoyer une demande de lecture de tampon au contrôleur de support d'après le message de réponse, la demande de lecture de tampon étant utilisée pour lire les données qui ont été écrites dans le tampon.
